# EUROPÄISCHE PATENTSCHRIFT

(11) **EP 2 655 468 B1**
(45) Veröffentlichungstag und Bekanntmachung des Hinweises auf die Patenterteilung: **19.11.2014**
(21) Anmeldenummer: 11799398.0
(22) Anmeldetag: 12.12.2011
(51) Int. Cl.: C08G 59/00, H05K 3/28

(54) **EPOXIDHARZ-ZUSAMMENSETZUNGEN ENTHALTEND EPOXY- UND VINYLESTERGRUPPEN**
EPOXY RESIN COMPOSITIONS CONTAINING EPOXY AND VINYL ESTER GROUPS
COMPOSITIONS DE RÉSINE ÉPOXYDE COMPRENANT DES GROUPES ÉPOXY ET ESTER VINYLIQUE

(30) Priorität: 21.12.2010 DE 102010063808
(43) Veröffentlichungstag der Anmeldung: 30.10.2013
(73) Patentinhaber: Elantas GMBH, 46483 Wesel (DE)
(72) Erfinder: SULZBACH, Horst, 46348 Raesfeld (DE); ZHOU, Meiyong, XiangZhou Zhuhai Guangdong 519000 (CN); CHEN, Wan Li, Hongqi Township, Jinwan Dist. Zhuhai, Guangdong, 519090 (CN)
(74) Vertreter: Schuck, Alexander
(86) Internationale Anmeldenummer: PCT/EP2011/072435
(87) Internationale Veröffentlichungsnummer: WO 2012/084569

(56) Entgegenhaltungen:
- EP-A1- 0 346 486
- EP-A2- 0 207 188
- EP-A2- 0 844 809
- US-A- 5 439 956

## Beschreibung

Die Erfindung betrifft Überzugsmassen enthaltend Epoxidharz-Zusammensetzungen enthaltend Epoxy- und Vinylestergruppen sowie deren Verwendung zum Isolieren von elektrischen und elektronischen Bauteilen und Geräten.

Gegenwärtig verwendete flüssige Standard-Zusammensetzungen für die Elektroisolation sind solche auf Basis von ungesättigten Polyestern (UP) oder Epoxidharzen (EP).

UP-Systeme, welche als Imprägnierharze zum Einsatz kommen, enthalten einen Reaktivverdünner wie beispielsweise Styrol und verursachen damit entsprechend hohe Monomer-Emissionen während der Aushärtung, oder sie sind monomerfrei mit der damit verbundenen höheren Viskosität. Die radikalische Polymerisation wird üblicherweise unter Verwendung eines thermischen Radikalstarters oder durch Bestrahlung mit UV-Licht eingeleitet.

Die zum Einsatz kommenden Epoxidharzsysteme werden heißgehärtet. Als Härterkomponente fungieren dabei entweder Säureanhydride oder aber, bei der katalytischen Härtung, Lewis-Säuren, beispielsweise BCl₃-Amin-Komplexe.

Eine umfangreichere Beschreibung von als Imprägnierharze verwendeten Polymeren findet sich in Horst Sulzbach (Herausgeber), "Polymers for Electrical Insulation", Verlag Moderne Industrie 2008, ISBN 978-3-937889-82-5 und den darin genannten weiteren Zitaten.

Epoxyvinylester weisen viele der vorteilhaften Eigenschaften von Epoxidharzsystemen wie gute Verarbeitbarkeit und Chemikalienbeständigkeit auf und können zudem in acrylischen Lösemitteln mit sehr niedrigen VOC-Gehalten verdünnt werden (VOC = volatile organic compounds, flüchtige organische Verbindungen). In US 5,984,647 wird die Verwendung solcher Systeme für die Imprägnierung eines hermetischen Motors beschrieben. Allerdings erreichen die Haftfestigkeiten dieser Systeme nicht die Werte, welche mit Epoxidharzsystemen prinzipiell möglich sind.

Die UV-Härtungseigenschaften von Epoxidharz-Zusammensetzungen mit nur teilweise umgesetzten Epoxygruppen werden von Saiki et al. im Journal of Applied Polymer Science 117 (2010) 3466- 3472 und von Park et al. im International Journal of Adhesives & Adhesives 29 (2009) 710 - 717 beschrieben. US 4,888,269 beschreibt solche Epoxygruppen und Acrylatgruppen enthaltenden Harze in Verbindung mit polyfunktionellen, Vinylgruppen-haltigen Reaktivverdünnern mit mehr als 2 Vinylgruppen, wobei die dort beschriebenen Systeme mit Aminen ausgehärtet und als lötbeständige Tinten verwendet werden.

Aufgabe der Erfmdung ist es, ein Imprägnierharzsystem bereitzustellen, welches die guten Haftungseigenschaften und die Langzeitstabilität von Epoxidharzsystemen mit der guten Elastizität Acrylatgruppen enthaltender Systeme verbindet, niedrig viskos ist und nur geringe Mengen an VOC enthält.

Gelöst wird die Aufgabe durch eine Überzugsmasse enthaltend
i) 100 Gew.-Teile einer Epoxidharz-Zusammensetzung enthaltend
   a) das Umsetzungsprodukt aus
      a1) einer oder mehreren Epoxyverbindungen mit mindestens 2 Epoxygruppen und
      a2) pro Mol Epoxygruppen 0,2 bis 0,9 mol Acrylsäure oder Methacrylsäure oder deren Gemischen,
         als Komponente A;
   b) ein Vinylgruppen enthaltendes Lösungsmittel als Komponente B;
   wobei das Vinylgruppen enthaltende Lösungsmittel der Komponente B zu mindestens 90 Gew.-% aus difunktionellen Vinylgruppen enthaltenden Lösungsmitteln, bezogen auf die Summe aller Vinylgruppen enthaltenden Lösungsmittel, besteht,
ii) 0,1 bis 10 Gew.-Teile eines Radikale bildenden Polymerisationsinitiators,
iii) 0,1 bis 5 Gew.-Teile eines Härters, der eine Lewissäure ist.

Überraschenderweise hat sich gezeigt, dass ein Epoxidharzsystem, in welchem die Oxirangruppen nur teilweise in Vinylestergruppen überführt wurden, eine den Epoxidharzen vergleichbare Haftfestigkeit zeigt und sich problemlos mit Reaktivverdünnern, welche eine Vinylgruppe und eine Esterfunktionalität besitzen, abmischen lässt.

Die erfindungsgemäß eingesetzten Epoxy-Vinylester-Hybridsysteme (EVHS) können heißgehärtet werden, wobei die Vinylestergruppen mittels eines Radikalstarters polymerisiert und die Epoxygruppen mittels einer hitzeaktivierten Lewissäure vernetzt werden.

So werden erfindungsgemäß Harzsysteme für die Elektroisolation mit hervorragender Temperaturbeständigkeit, Haftung und elektrischen Isolierungseigenschaften im ausgehärteten Zustand bereitgestellt. Das Harz kann alleine oder in Kombination mit festen Isoliermaterialen (Bändern etc.) dazu verwendet werden, elektrische Geräte wie Motoren, Transformatoren und Generatoren zu isolieren.

Die erfmdungsgemäß eingesetzten Epoxidharz-Zusammensetzungen enthalten ein Teilumsetzungs-produkt eines oder mehrerer Epoxy-funktioneller Verbindungen mit 2 oder mehr Epoxygruppen mit Acrylsäure oder Methacrylsäure, wobei nicht alle Epoxygruppen umgesetzt werden und somit noch Oxiranringe im Molekül verbleiben. Dieses Teilumsetzungsprodukt wird mit einem Reaktivverdünner, der Vinylgruppen enthält, verdünnt.

Geeignete Epoxy-funktionelle Verbindungen mit mindestens 2 Epoxygruppen sind die Diglycidylester von Bisphenol A und Bisphenol F, bevorzugt ist der Diglycidylester von Bisphenol A. Geeignete Epoxy-funktionelle Verbindungen mit mindestens 2 Epoxygruppen sind weiterhin Epoxyverbindungen auf Basis von Phenolnovolak oder Kresolnovolak. Diese werden durch Umsetzung von Phenol-Formaldehyd-Harzen bzw. Kresol-Formaldehyd-Harzen mit Epichlorhydrin oder Methylepichlorhydrin als Glycidylether bzw. Methylglycidylether erhalten. Geeignete Phenolnovolak-(Methyl)glycidylether und Kresolnovolak-(Methyl)glycidylether weisen im Allgemeinen einen Schmelzpunkt im Bereich von 60 bis 120 °C, bevorzugt von 70 bis 100 °C, und weisen pro Molekül im Mittel 2 bis 20, bevorzugt 3 bis 10 Epoxygruppen auf.

Die Epoxy-funktionellen Verbindungen werden in Gegenwart eines Veresterungskatalysators mit Acrylsäure oder Methacrylsäure bei Temperaturen von im Allgemeinen 60 bis 140 °C, bevorzugt 80 bis 120 °C umgesetzt. Geeignete Veresterungskatalysatoren sind tertiäre Amine wie Triethylamin oder Diazabicyclooctan oder quaternäre Ammoniumsalze, beispielsweise Tetramethylammoniumchlorid.

Bevorzugt ist ein Umsetzungsprodukt aus
a1) einer oder mehreren Epoxyverbindungen mit mindestens 2 Epoxygruppen, und
a2) pro Mol Epoxygruppen 0,3 bis 0,7 mol, besonders bevorzugt 0,35 bis 0,65 mol Acrylsäure oder Methacrylsäure oder deren Gemischen.

Geeignete Vinylgruppen enthaltende Lösungsmittel - auch als Reaktivverdünner bezeichnet - sind monofunktionelle, difunktionelle und polyfunktionelle Reaktivverdünner mit im Allgemeinen 1 bis 6 Vinylgruppen. Bevorzugt sind die Acrylate und Methacrylate von Diolen und Polyolen mit im Allgemeinen 2 bis 6 OH-Gruppen. Besonders bevorzugt sind die Acrylate und Methacrylate von Diolen, beispielsweise Butandioldi(meth)acrylat, Hexandioldi(meth)acrylat, Diethylenglykoldi(meth)acrylat, Triethylenglycoldi(meth)-acrylat, Dipropylenglykoldi(meth)acrylat, Tripropylenglykoldi(meth)acrylat, sowie weitere, großtechnisch hergestellte Di(meth)acrylate.

Geeignete polyfunktionelle Reaktivverdünner mit 3 bis 6 Vinylgruppen sind beispielsweise die (Meth)acrylsäureester von Trimethylolpropan, Pentaerythritol oder Dipentaerythritol, oder die Allylalkoholester von Trimellith- oder Pyromellithsäure.

3- oder mehrfunktionelle Reaktivverdünner können zur Erhöhung der Vemetzungsdichte auch zusammen mit difunktionellen Reaktivverdünnern eingesetzt werden.

Daneben können Reaktivverdünner mit nur einer Vinylgruppe mitverwendet werden. Beispiele sind Butyl(meth)acrylat, Hexyl(meth)acrylat und Octyl(meth)acrylat.

Bevorzugt enthalten die erfindungsgemäßen Epoxidharz-Zusammensetzungen bzw. Überzugsmassen - bezogen auf die Summe aller Reaktivverdünner - mindestens 90 Gew.-%, besonders bevorzugt mindestens 95 Gew.-%, insbesondere ausschließlich difunktionelle Reaktivverdünner, also solche mit 2 Vinylgruppen, beispielsweise Butandioldi(meth)acrylat.

Im Allgemeinen enthalten die erfindungsgemäßen Epoxidharz-Zusammensetzungen 40 bis 70 Gew.-%, bevorzugt 45 bis 65 Gew.-% Umsetzungsprodukt aus Epoxyverbindung und (Meth)acrylsäure (Komponente A) und 23 bis 58 Gew.-%, bevorzugt 30 bis 48 Gew.-% Vinylgruppen enthaltendes Lösungsmittel (Reaktivverdünner, Komponente B), wobei die Summe der Komponenten A und B 100 Gew.-% ergibt.

Die Epoxidharz-Zusammensetzungen werden nach einem sogenannten dualen Mechanismus gehärtet, wobei zum einen die Epoxygruppen mittels einer Lewissäure als Katalysator gehärtet werden, und zum anderen die Doppelbindungen der (Meth)acrylgruppen mittels eines durch Hitze oder UV-Licht aktivierbaren, Radikale bildenden Polymerisationsinitiator vernetzt werden.

Geeignete Radikale bildende Polymerisationsinitiatoren ii) sind die dem Fachmann bekannten Polymerisationsinitiatoren. Bevorzugte mittels UV-Licht aktivierbare Polymerisationsinitiatoren sind 4,4'-Dimethylbenzylketal, 4,4'-Dimethoxybenzoin, Benzoinmethylether und 2,4,6-Trimethylbenzoyldiphenylphosphinoxid.

Bevorzugte mittels Hitze aktivierbare Polymerisationsinitiatoren sind Dicumylperoxid, Di-tert.-Butylperoxid und tert.-Butylperbenzoat.

Geeignete Lewissäuren sind Komplexe von BF₃ oder BCl₃ mit tertiären Aminen, im Allgemeinen Tri-C₁-C₁₀-alkylaminen, beispielsweise BCl₃-Dimethyloctylamin, BF₃-Trimethylamin und BF₃-Tributylamin.

In einer besonders bevorzugten Ausführungsform der Erfindung werden als Härter Lewissäuren eingesetzt.

Die Erfindung betrifft auch die Verwendung der Epoxidharz-Zusammensetzungen und der Überzugsmassen zum Isolieren von elektrischen und elektronischen Bauteilen und Geräten. Die Erfindung betrifft insbesondere die Verwendung der Zusammensetzungen und Überzugsmassen zum Isolieren von elektrischen und elektronischen Bauteilen und Geräten, die in Berührung mit flüssigen oder dampfförmigen organischen Chemikalien oder Lösungsmitteln, beispielsweise Kühlflüssigkeiten stehen. Beispiele sind in Kühlaggregaten eingesetzte Elektromotoren, die in Kontakt mit einer Atmosphäre aus dampfförmiger Kühlflüssigkeit oder mit der Kühlflüssigkeit selbst stehen. Beispiele für solche Kühlflüssigkeiten sind Frigene mit der Bezeichnung Frigen 22 und Frigen 410. Solche Bauteile oder Geräte müssen gegen ihre Umgebung hermetisch abgeschirmt sein, weswegen auch von "Hermetik-Anwendungen" gesprochen wird.

Die Erfindung wird durch die nachstehenden Beispiele näher erläutert.

### Beispiele

### Beispiel 1

Ein Dreihalskolben mit Thermometer, Rührer und Rückflusskühler wird beschickt mit 633,6 g Bisphenol A-Epoxidharz (Handelsname E44, Epoxidäquivalent von 227,27 g/mol, entsprechend 2,788 Epoxidgruppen), 100,45 g Acrylsäure (entsprechend 1,394 Carboxylgruppen), 0,528 g Hydrochinon und 0,6336 g Tetramethylammoniumchlorid. Das Gemisch wird auf 105 °C erhitzt. Nach 3 Stunden weist das Gemisch eine Säurezahl von 1,0 mg KOH/g.

Diese Harzmischung wird im nachfolgenden Text mit A-1 bezeichnet.

### Beispiele 2 und 3

Es wird wie in Beispiel 1 verfahren, jedoch mit den in Tabelle 1 angegebenen Mengen der einzelnen Komponenten.

**Tabelle 1**

| | Beispiele | |
|---|---|---|
| | 2 | 3 |
| Epoxidharz E-44 | 633,6 g | 633,6 g |
| Acrylsäure | 85 g | 115 g |
| Tetramethylammoniumchlorid | 0,5 g | 0,8 g |
| Hydrochinon | 0,4 g | 0,7 g |
| | | |
| Säurezahl | 0,2 mg KOH/g | 1,5 mg KOH/g |
| Harzbezeichnung | A-2 | A-3 |

### Beispiel 4

620,26 g eines Kresolnovolaks des Typs "F-51" (Epoxidäquivalent von 196,08 g/mol, entsprechend im Mittel 3,162 Epoxygruppen pro Molekül) werden auf 65°C erwärmt. 0,4 g Hydrochinon, 94,91 g Acrylsäure (entsprechend 1,317 Carboxylgruppen pro Molekül der Epoxyyverbindung) und 0,738 g Tetramethylammoniumchlorid werden zugegeben und bei 105 °C an Luft reagieren gelassen. Bei Abfallen der Säurezahl unter 1 mg KOH/g wird die Reaktion durch Abkühlen abgebrochen. Das erhaltene Harz wird als A-4 bezeichnet.

### Beispiele 5 und 6

Die Harze A-5 und A-6 werden, wie in Beispiel 4 beschrieben, mit den in der Tabelle 2 aufgeführten Mengen der einzelnen Komponenten hergestellt.

**Tabelle 2**

| | Beispiele | |
|---|---|---|
| | 5 | 6 |
| Kreso lnovo lak F-51 | 620,26 g | 620,26 g |
| Acrylsäure | 80 g | 115 g |
| Tetramethylammoniumchlorid | 0,5 g | 0,9 g |
| Hydrochinon | 0,3 g | 0,5 g |
| | | |
| Säurezahl | 0,15 mg KOH/g | 1,14 mg KOH/g |
| Harzbezeichnung | A-5 | A-6 |

### Beispiele 7 bis 11

Durch Vermischen der Harze A-1 bis A-6 mit Butandioldimethacrylat, Dicumylperoxid und Bortrichlorid-Dimethyloctylamin-Komplex wurden ausformulierte Tränkharz-Beschichtungszusammensetzungen für die Elektroisolation hergestellt. Deren Zusammensetzungen und Eigenschaften sind in Tabelle 3 wiedergegeben.

**Tabelle 3**

| | Beispiele | | | | |
|---|---|---|---|---|---|
| | 7 | 8 | 9 | 10 | 11 |
| A-1 | | | 35 g | | |
| A-2 | 65 g | | | 40 g | |
| A-3 | | | | | 43 g |
| A-4 | | | 25 g | | |
| A-5 | | 60 g | | 19 g | |
| A-6 | | | | | 16 g |
| Butandioldimethacrylat | 35 g | 40 g | 40 g | 41 g | 38 g |
| Dicumylperoxid | 1 g | 1 g | 1 g | 1 g | 1 g |
| BCl₃-Dimethyloctylamin | 2 g | 2 g | 2g | 2 g | 2 g |
| | | | | | |
| Eigenschaften | | | | | |
| Viscosität (mPa·s, 23°C) | 320 | 525 | 500 | 427 | 395 |
| Gelzeit in min, 8g@120°C | 5,51 | 4,82 | 4,96 | 5,10 | 5,28 |
| Verbackungsfestigkeit, bei 23°C in N | 243 | 334 | 296 | 283 | 262 |
| Shore Härte D | 68 | 102 | 95 | 84 | 75 |

Die Gelzeit wird nach DIN 16945 bestimmt und die Verbackungsfestigkeit nach der IEC 61033 bestimmt.

Für den Einsatz von mit Tränkharz imprägnierten Wicklungen in hermetischen Motoren, z.B. in Kühlschränken, muss ein so genannter Öl-Test bestanden werden. Dieser wird wie folgt durchgeführt:
Wickellocken aus MW 35 Lackdraht werden wie in ASTM D 2519 beschrieben hergestellt. Die Wickellocken werden in das Tränkharz getaucht und für 3 Stunden bei 150 °C ausgehärtet. Eine Parr-Bombe wird mit 500 ml Mineralöl gefüllt. 5 Wickellocken werden in das Öl gegeben. Die Bombe wird verschlossen. Danach wird sie über ein Ventil mit ca. 0,5 kg Frigen R 22 (bzw. 410) gefüllt. Die Bombe wird für 168 Stunden bei 120 °C gelagert. Nach dem Abkühlen und Entspannen werden die Wickellocken entnommen und mit Papier abgetrocknet. Die Verbackungsfestigkeit wird geprüft und mit der vor dem Öltest verglichen. Ein 10 %-iger Abfall ist noch tolerabel.

Die Verbackungsfestigkeiten nach ASTM2519-2 in N sind in Tabelle 4 wiedergegeben.

**Tabelle 4**

| | Beispiele | | | | |
|---|---|---|---|---|---|
| | 7 | 8 | 9 | 10 | 11 |
| vor dem Öl-Test | 243,10 | 334,52 | 296,78 | 283,09 | 262,40 |
| nach dem Öl-Test | 221,73 | 326,11 | 290,04 | 277,45 | 238,52 |

### Vergleichsbeispiel 1

Ein Imprägnierharz, welches keine freien Oxirangruppen enthält und wie es in Beispiel 1 der US 5 984 647 beschrieben ist, wird hergestellt und wie oben beschrieben geprüft.

Die Ergebnisse im Vergleich zu den Ergebnissen des Beispiels 11 sind in der Tabelle 5 wiedergegeben.

Die Durchschlagsfestigkeit (Durchschlagsspannung) wurde nach IEC 60464 Teil 2 bestimmt und die Extraktionswerte durch das Wiegen der Wickellocken vor und nach dem Öltest.

**Tabelle 5**

| | Tränkharz | |
|---|---|---|
| | Beispiel 11 | Vergleichsbeispiel 1 |
| Durchschlagsspannung (V/my) | 1,59 | 1,32 |
| R22-Extraktion (%) | 0,21 | 0,37 |
| R 410-Extraktion (%) | 0,18 | 0,21 |
| Verbackungsfestigkeit(N) vor dem Öltest | 262 | 117 |
| Verbackungsfestigkeit(N) nach dem Öltest | 238 | 113 |

Das erfindungsgemäße Tränkharz gemäß Beispiel 11 hat niedrigere Extraktionswerte und eine doppelt so hohe Verbackungsfestigkeit als das Tränkharz gemäß Vergleichsbeispiel 1.

## Patentansprüche

1. Überzugsmasse enthaltend
i) 100 Gew.-Teile einer Epoxidharz-Zusammensetzung enthaltend
a) das Umsetzungsprodukt aus
a1) einer oder mehreren Epoxyverbindungen mit mindestens 2 Epoxygruppen, und
a2) pro mol Epoxygruppen 0,2 bis 0,9 mol Acrylsäure oder Methacrylsäure oder deren Gemischen,
als Komponente A;
b) ein Vinylgruppen enthaltendes Lösungsmittel als Komponente B; wobei das Vinylgruppen enthaltende Lösungsmittel der Komponente B zu mindestens 90 Gew.-% aus difunktionellen Vinylgruppen enthaltenden Lösungsmitteln, bezogen auf die Summe aller Vinylgruppen enthaltenden Lösungsmittel, besteht,
ii) 0,1 bis 10 Gew.-Teile eines Radikale bildenden Polymerisationsinitiators,
iii) 0,1 bis 5 Gew.-Teile eines Härters, der eine Lewissäure ist.

2. Überzugsmasse nach Anspruch 1, **dadurch gekennzeichnet, dass** in der Komponente A pro mol Epoxygruppen 0,3 bis 0,7 mol Acrylsäure oder Methacrylsäure oder deren Gemische umgesetzt werden.

3. Überzugsmasse nach Anspruch 1 oder 2, **dadurch gekennzeichnet, dass** in Komponete A Bisphenol A-Diglycidylether als Epoxyverbindung a1) umgesetzt wird.

4. Überzugsmasse nach Anspruch 1 oder 2, **dadurch gekennzeichnet, dass** in Komponente A ein Phenolnovolak-Glycidylether als Epoxyverbindung al) umgesetzt wird.

5. Überzugsmasse nach Anspruch 1 oder 2, **dadurch gekennzeichnet, dass** in Komponente A ein Kresolnovolak-Glycidylether als Epoxyverbindung a1) umgesetzt wird.

6. Überzugsmasse nach einem der Ansprüche 1 bis 5, **dadurch gekennzeichnet, dass** das Vinylgruppen enthaltende Lösungsmittel der Komponente B ausgewählt ist aus der Gruppe bestehend aus Butandioldi(meth)acrylat, Hexandioldi(meth)acrylat, Diethylenglykoldi(meth)acrylat, Triethylenglycoldi(meth)acrylat, Dipropylenglykoldi(meth)acrylat und Tripropylenglykoldi(meth)acrylat.

7. Überzugsmasse nach einem der Ansprüche 1 bis 6, **dadurch gekennzeichnet, dass** die Lewissäure ein Komplex aus BF₃ oder BCl₃ und einem tertiären Amin ist.

8. Verwendung der Überzugsmassen gemäß einem der Ansprüche 1 bis 7 zum Isolieren von elektrischen und elektronischen Bauteilen und Geräten.

9. Verwendung von Epoxidharz-Zusammensetzung enthaltend
a) das Umsetzungsprodukt aus
a1) einer oder mehreren Epoxyverbindungen mit mindestens 2 Epoxygruppen, und
a2) pro mol Epoxygruppen 0,2 bis 0,9 mol Acrylsäure oder Methacrylsäure oder deren Gemischen,
als Komponente A;
b) ein Vinylgruppen enthaltendes Lösungsmittel als Komponente B, zum Isolieren von in Kühlaggregaten eingesetzten Elektromotoren.

10. Verwendung nach Anspruch 9, **dadurch gekennzeichnet, dass** in Komponete A Bisphenol A-Diglycidylether als Epoxyverbindung a1) umgesetzt wird.

11. Verwendung nach Anspruch 9, **dadurch gekennzeichnet, dass** in Komponente A ein Phenolnovolak-Glycidylether als Epoxyverbindung a1) umgesetzt wird.

12. Verwendung nach Anspruch 9, **dadurch gekennzeichnet, dass** in Komponente A ein Kresolnovolak-Glycidylether als Epoxyverbindung a1) umgesetzt wird.

13. Verwendung nach einem der Ansprüche 9 bis 12, **dadurch gekennzeichnet, dass** das Vinylgruppen enthaltende Lösungsmittel der Komponente B zu mindestens 90 Gew.-% aus difunktionellen Vinylgruppen enthaltenden Lösungsmitteln, bezogen auf die Summe aller Vinylgruppen enthaltenden Lösungsmittel, besteht.

14. Verwendung nach einem der Ansprüche 9 bis 13, **dadurch gekennzeichnet, dass** das Vinylgruppen enthaltende Lösungsmittel der Komponente B ausgewählt ist aus der Gruppe bestehend aus Butandioldi(meth)acrylat, Hexandioldi(meth)acrylat, Diethylenglykoldi(meth)acrylat, Triethylenglycoldi(meth)acrylat, Dipropylenglykoldi(meth)acrylat und Tripropylenglykoldi(meth)acrylat.

15. Verwendung einer Überzugsmasse enthaltend
i) 100 Gew.-Teile einer Epoxidharz-Zusammensetzung wie in einem der Ansprüche 9 bis 14 definiert,
ii) 0,1 bis 10 Gew.-Teile eines Radikale bildenden Polymerisationsinitiators,
iii) 0,1 bis 5 Gew.-Teile eines Härters,
zum Isolieren von in Kühlaggregaten eingesetzten Elektromotoren.

16. Verwendung nach Anspruch 15, **dadurch gekennzeichnet, dass** der Härter iii) eine Lewissäure ist.

17. Verwendung nach Anspruch 16, **dadurch gekennzeichnet, dass** die Lewissäure ein Komplex aus BF₃ oder BCl₃ und einem tertiären Amin ist.

18. Verwendung nach Anspruch 15, **dadurch gekennzeichnet, dass** der Härter iii) ein Carbonsäureanhydrid ist.

## Claims

1. Coating compostion comprising
i) 100 parts by weight of an epoxy resin composition comprising
a) the reaction product formed from
a1) one or more epoxy compounds having at least two epoxy groups, and
a2) 0.2 to 0.9 mol of acrylic acid or methacrylic acid or mixtures thereof per mole of epoxy groups, as component A;
b) a solvent comprising vinyl groups as component B; the solvent comprising vinyl groups of component B consisting to an extent of at least 90% by weight of solvents comprising difunctional vinyl groups, based on the sum of all solvents comprising vinyl groups,
ii) 0.1 to 10 parts by weight of a free radicalforming polymerization initiator,
iii) 0.1 to 5 parts by weight of a hardener, which is a Lewis acid.

2. Coating composition according to Claim 1, **characterized in that**, in component A, 0.3 to 0.7 mol of acrylic acid or methacrylic acid or mixtures thereof per mole of epoxy groups is reacted.

3. Coating composition according to Claim 1 or 2, **characterized in that**, in component A, the epoxy compound a1) converted is bisphenol A diglycidyl ether.

4. Coating composition according to Claim 1 or 2, **characterized in that**, in component A, the epoxy compound a1) converted is a phenol novolac glycidyl ether.

5. Coating composition according to Claim 1 or 2, **characterized in that**, in component A, the epoxy compound a1) converted is a cresol novolac glycidyl ether.

6. Coating composition according to any of Claims 1 to 5, **characterized in that** the solvent comprising vinyl groups of component B is selected from the group consisting of butanediol di(meth)acrylate, hexanediol di(meth)acrylate, diethylene glycol di(meth)acrylate, triethylene glycol di(meth)acrylate, dipropylene glycol di(meth)acrylate and tripropylene glycol di(meth)acrylate.

7. Coating composition according to any of Claims 1 to 6, **characterized in that** the Lewis acid is a complex of BF₃ or BCl₃ and a tertiary amine.

8. Use of the coating compositions according to any of Claims 1 to 7 for insulation of electric and electronic components and devices.

9. Use of epoxy resin composition comprising
a) the reaction product formed from
a1) one or more epoxy compounds having at least two epoxy groups, and
a2) 0.2 to 0.9 mol of acrylic acid or methacrylic acid or mixtures thereof per mole of epoxy groups, as component A;
b) a solvent comprising vinyl groups as component B, for insulation of electric motors used in cooling units.

10. Use according to Claim 9, **characterized in that**, in component A, the epoxy compound a1) converted is bisphenol A diglycidyl ether.

11. Use according to Claim 9, **characterized in that**, in component A, the epoxy compound a1) converted is a phenol novolac glycidyl ether.

12. Use according to Claim 9, **characterized in that**, in component A, the epoxy compound a1) converted is a cresol novolac glycidyl ether.

13. Use according to any of Claims 9 to 12, **characterized in that** the solvent comprising vinyl groups of component B consists to an extent of at least 90% by weight of solvents comprising difunctional vinyl groups, based on the sum of all solvents comprising vinyl groups.

14. Use according to any of Claims 9 to 13, **characterized in that** the solvent comprising vinyl groups of component B is selected from the group consisting of butanediol di(meth)acrylate, hexanediol di(meth)acrylate, diethylene glycol di(meth)acrylate, triethylene glycol di(meth)acrylate, dipropylene glycol di(meth)acrylate and tripropylene glycol di(meth)acrylate.

15. Use of a coating composition comprising
i) 100 parts by weight of an epoxy resin composition as defined in any of Claims 9 to 14,
ii) 0.1 to 10 parts by weight of a free radical-forming polymerization initiator,
iii) 0.1 to 5 parts by weight of a hardener,
for insulation of electric motors used in cooling units.

16. Use according to Claim 15, **characterized in that** the hardener iii) is a Lewis acid.

17. Use according to Claim 16, **characterized in that** the Lewis acid is a complex of BF₃ or BCl₃ and a tertiary amine.

18. Use according to Claim 15, **characterized in that** the hardener iii) is a carboxylic anhydride.

## Revendications

1. Matériau de revêtement, contenant :
i) 100 parties en poids d'une composition de résine époxyde contenant :
a) le produit de réaction de
a1) un ou plusieurs composés époxy contenant au moins 2 groupes époxy et
a2) par mole de groupes époxy, 0,2 à 0,9 mole d'acide acrylique ou d'acide méthacrylique ou leurs mélanges,
en tant que composant A ;
b) un solvant contenant des groupes vinyle en tant que composant B ;
le solvant contenant des groupes vinyle du composant B étant constitué d'au moins 90 % en poids de solvants contenant des groupes vinyle bifonctionnels, par rapport à la somme de tous les solvants contenant des groupes vinyle,
ii) 0,1 à 10 parties en poids d'un initiateur de polymérisation formant des radicaux,
iii) 0,1 à 5 parties en poids d'un durcisseur qui est un acide de Lewis.

2. Matériau de revêtement selon la revendication 1, **caractérisé en ce que** 0,3 à 0,7 mole d'acide acrylique ou d'acide méthacrylique ou leurs mélanges sont mis en réaction dans le composant A, par mole de groupes époxy.

3. Matériau de revêtement selon la revendication 1 ou 2, **caractérisé en ce que**, dans le composant A, un éther diglycidylique de bisphénol A est mis en réaction en tant que composé époxy a1).

4. Matériau de revêtement selon la revendication 1 ou 2, **caractérisé en ce que**, dans le composant A, un éther glycidylique de phénol-novolac est mis en réaction en tant que composé époxy a1).

5. Matériau de revêtement selon la revendication 1 ou 2, **caractérisé en ce que**, dans le composant A, un éther glycidylique de crésol-novolac est mis en réaction en tant que composé époxy a1).

6. Matériau de revêtement selon l'une quelconque des revendications 1 à 5, **caractérisé en ce que** le solvant contenant des groupes vinyle du composant B est choisi dans le groupe constitué par le di(méth)acrylate de butanediol, le di(méth)acrylate d'hexanediol, le di(méth)acrylate de diéthylène glycol, le di(méth)acrylate de triéthylène glycol, le di(méth)acrylate de dipropylène glycol et le di(méth)acrylate de tripropylène glycol.

7. Matériau de revêtement selon l'une quelconque des revendications 1 à 6, **caractérisé en ce que** l'acide de Lewis est un complexe de BF₃ ou BCl₃ et d'une amine tertiaire.

8. Utilisation des matériaux de revêtement selon l'une quelconque des revendications 1 à 7 pour l'isolement de composants et d'appareils électriques et électroniques.

9. Utilisation d'une composition de résine époxyde contenant :
a) le produit de réaction de
a1) un ou plusieurs composés époxy contenant au moins 2 groupes époxy et
a2) par mole de groupes époxy, 0,2 à 0,9 mole d'acide acrylique ou d'acide méthacrylique ou leurs mélanges,
en tant que composant A ;
b) un solvant contenant des groupes vinyle en tant que composant B ;
pour l'isolement de moteurs électriques utilisés dans des appareils réfrigérants.

10. Utilisation selon la revendication 9, **caractérisée en ce que** dans le composant A, un éther diglycidylique de bisphénol A est mis en réaction en tant que composé époxy a1).

11. Utilisation selon la revendication 9, **caractérisée en ce que**, dans le composant A, un éther glycidylique de phénol-novolac est mis en réaction en tant que composé époxy a1).

12. Utilisation selon la revendication 9, **caractérisée en ce que**, dans le composant A, un éther glycidylique de crésol-novolac est mis en réaction en tant que composé époxy a1).

13. Utilisation selon l'une quelconque des revendications 9 à 12, **caractérisée en ce que** le solvant contenant des groupes vinyle du composant B est constitué d'au moins 90 % en poids de solvants contenant des groupes vinyle bifonctionnels, par rapport à la somme de tous les solvants contenant des groupes vinyle.

14. Utilisation selon l'une quelconque des revendications 9 à 13, **caractérisée en ce que** le solvant contenant des groupes vinyle du composant B est choisi dans le groupe constitué par le di(méth)acrylate de butanediol, le di(méth)acrylate d'hexanediol, le di(méth)acrylate de diéthylène glycol, le di(méth)acrylate de triéthylène glycol, le di(méth)acrylate de dipropylène glycol et le di(méth)acrylate de tripropylène glycol.

15. Utilisation d'un matériau de revêtement contenant :
i) 100 parties en poids d'une composition de résine époxyde telle que définie dans l'une quelconque des revendications 9 à 14,
ii) 0,1 à 10 parties en poids d'un initiateur de polymérisation formant des radicaux,
iii) 0,1 à 5 parties en poids d'un durcisseur,
pour l'isolement de moteurs électriques utilisés dans des appareils réfrigérants.

16. Utilisation selon la revendication 15, **caractérisée en ce que** le durcisseur iii) est un acide de Lewis.

17. Utilisation selon la revendication 16, **caractérisée en ce que** l'acide de Lewis est un complexe de BF₃ ou BCl₃ et d'une amine tertiaire.

18. Utilisation selon la revendication 15, **caractérisée en ce que** le durcisseur iii) est un anhydride d'acide carboxylique.
